# EUROPÄISCHE PATENTSCHRIFT

(11) **EP 3 379 293 B1**
(45) Veröffentlichungstag und Bekanntmachung des Hinweises auf die Patenterteilung: **01.04.2020**
(21) Anmeldenummer: 18158042.4
(22) Anmeldetag: 22.02.2018
(51) Int. Cl.: G01S 17/48, G01V 8/20

(54) **OPTOELEKTRONISCHER SENSOR UND VERFAHREN ZUM ERFASSEN VON OBJEKTEN**
OPTOELECTRONIC SENSOR AND METHOD FOR DETECTING OBJECTS
CAPTEUR OPTOÉLECTRONIQUE ET PROCÉDÉ DESTINÉ À LA SAISIE D'OBJETS

(30) Priorität: 24.03.2017 DE 102017106380
(43) Veröffentlichungstag der Anmeldung: 26.09.2018
(73) Patentinhaber: SICK AG, 79183 Waldkirch (DE)
(72) Erfinder: Waslowski, Kai, 79312 Emmendingen (DE); Hörsch, Ingolf, 79102 Freiburg (DE); Merettig, Gerhard, 79350 Sexau (DE); Götz, Matthias, 79104 Freiburg (DE)

(56) Entgegenhaltungen:
- EP-A1- 1 816 488
- EP-A2- 2 026 104
- DE-A1- 4 031 995
- DE-A1-102005 019 909
- DE-C2- 19 721 105

## Beschreibung

Die Erfindung betrifft einen optoelektronischen Sensor und ein Verfahren zur Erfassung von Objekten in einem Überwachungsbereich nach dem Oberbegriff von Anspruch 1 beziehungsweise 13.

Viele optoelektronische Sensoren haben einen Empfangskanal mit einer abbildenden Optik oder Empfangslinse und einem zeilen- oder matrixförmigen Empfänger aus einer Vielzahl von Empfangselementen oder Pixeln. So kann einerseits ein ortsaufgelöstes Signal erzeugt werden, um den Empfangslichtfleck zu charakterisieren oder aus der Lichtfleckposition Kalibrier- oder Messinformationen zu gewinnen. Andererseits besteht die Möglichkeit, Pixel zu einer Gruppe oder wenigen Gruppen miteinander zu verbinden, etwa über eine Parametrierung, und deren gemeinsames Signal, insbesondere Summensignal, zu einem Objektfeststellungssignal zu verarbeiten.

Eine spezielle Klasse innerhalb dieser Sensoren nutzt das optische Messprinzip der Triangulation. Dabei stellt die Lichtfleckposition auf einem Empfängerelement ein Maß für den Objektabstand dar. Hierbei kann man nochmals zwischen Sensoren für eine tatsächliche Entfernungsmessung, die ein Beispiel für eine Auswertung des ortsaufgelösten Signals sind, und Reflexionstastern mit Hintergrundausblendung beziehungsweise hintergrundausblendenden Lichttastern (HGA-Taster) unterscheiden, die ein Beispiel für eine gruppenweise Verarbeitung zu einem Objektfeststellungssignal bilden. Ein hintergrundausblendender Lichttaster erkennt die Anwesenheit von Objekten und gibt dies üblicherweise in Form eines binären Schaltsignals aus. Dabei wird das Triangulationsprinzip ausgenutzt, um mit einem zumindest in einen Nah- und einen Fernbereich ortsauflösenden Lichtempfänger zwei Empfangssignale zu erzeugen. Deren Differenz wird mit einer Schaltschwelle nahe oder gleich Null bewertet, um so die Objekterfassung auf einen bestimmten Entfernungsbereich zu beschränken und Empfangssignale von Objekten außerhalb dieses Entfernungsbereichs als Hintergrundsignal auszublenden. Ein hintergrundausblendender Lichttaster ist beispielsweise in der DE 197 21 105 C2 offenbart, wobei hier Schalter vorgesehen sind, um die einzelnen Elemente eines ortsauflösenden Lichtempfängers auf veränderliche Weise dem Nah- oder Fernbereich zuzuordnen.

In einer einfachen Umsetzung genügt als Lichtempfänger eine Differenz-Diode. Der Schaltpunkt wird durch die Grenze zwischen deren Nah- und Fernelement festgelegt. Durch eine mechanische Verstellung der Position der Empfängerlinse oder des Empfangsbauteils kann der Schaltpunkt eingestellt werden. Soll der Schaltpunkt elektronisch verändert werden, so wird ein Empfangselement mit einer Vielzahl von kleinen Lichtempfangselementen oder Pixel verwendet, also eine Empfängerzeile, und die mechanische Verstellung wird durch das Bilden je einer Gruppe von Lichtempfangselementen für den Nah- und Fernbereich ersetzt.

Die Empfangssignale werden nicht als Rohsignale verarbeitet. Vielmehr werden sie für eine ausreichende Robustheit im industriellen Umfeld aufwändig analog und digital aufbereitet. Dieser Aufwand kann wirtschaftlich nur für eine begrenzte Anzahl von Empfangssignalen und keineswegs jedes einzelne Pixel dargestellt werden. Deshalb werden die Einzelsignale der Lichtempfangselemente zunächst zu wenigen Empfangskanälen zusammengefasst, die dann mit der geforderten Zuverlässigkeit und einer sehr hohen zeitlichen Auflösung arbeiten. Ein Nachteil dieses Konzepts ist, dass die Entfernung zum Objekt bei dieser Art der Messung nicht als Messgröße mit abfällt. Es ist nur bekannt, ob das Objekt vor oder hinter dem eingestellten Schaltpunkt liegt.

Ein Triangulationstaster zur Abstandsmessung dagegen arbeitet mit einer pixelbasierten Signalverarbeitung. Jede einzelne Fotodiode der Empfängerzeile integriert das Empfangssignal separat auf. Nach der Signalaufnahme werden alle Pixel sequentiell ausgelesen und digitalisiert. Wie oben schon ausgeführt, ist es nicht möglich, für so viele Einzelsignale eine Signalaufbereitung zu leisten, die dem entspricht, was herkömmlich in einem hintergrundausblendenden Lichttaster umgesetzt werden kann. Ein abstandsmessender Triangulationstaster hat eine reduzierte Gleichlichtfestigkeit und einen reduzierten Dynamikbereich, da jeder Pixel immer das komplette Empfangslicht aus Nutzlicht und Störlicht integriert. Außerdem ist die Störlichtunterdrückung schlecht, weil eine zeitliche Störlichtfilterung bei einer hohen Samplingrate am Pixel nicht möglich ist. Schließlich ergibt sich auch eine recht hohe Ansprechzeit, weil für jede Messung die Empfangssignale sehr vieler Pixel ausgelesen, digitalisiert und ausgewertet werden müssen. Man kann also sagen, dass die hohe zeitliche Messauflösung mit hoher Schaltfrequenz und guter Störunterdrückung eines hintergrundausblendenden Lichttasters gegen eine hohe geometrische Auflösung ausgetauscht wird.

Es ist im Stand der Technik auch bekannt, in einem hintergrundausblendenden Lichttaster die einzelnen Empfangssignale aller Pixel zu erfassen, also die Empfängerzeile quasi abzuscannen. Das ersetzt und blockiert damit die Schaltsignalerzeugung und ist deshalb nur außerhalb des eigentlichen Betriebs beispielsweise in einem Diagnosemodus möglich. Solche herkömmlichen Sensoren können demnach nur alternativ eine Anwesenheit von Objekten bei voller Schaltfrequenz leisten oder die Empfängerzeile abscannen, weil die beiden unterschiedlichen Betrachtungen der Empfangssignale einander ausschließen.

Aus der EP 1 816 488 A1 ist ein nach dem Triangulationsprinzip ausgebildeter optischer Sensor bekannt, der ein binäres Schaltsignal ausgibt. Die Empfangselemente einer Empfängerzeile werden zu verschiedenen Bereichen wie einem Fern- und Nahbereich zusammengefasst. Die Zugehörigkeit der Empfangselemente zu einem jeweiligen Bereich wird vorab eingelernt. In einer Ausführungsform ist jedem Empfangselement ein Ladungsspeicher zugeordnet, der mittels eines Schalterpaares wahlweise auf- oder abintegriert werden kann.

Deshalb ist Aufgabe der Erfindung, einen Sensor mit ortsaufgelöstem Lichtempfänger und Erzeugen eines Schaltsignals weiter zu verbessern.

Diese Aufgabe wird durch einen optoelektronischen Sensor und ein Verfahren zum Erfassung von Objekten in einem Überwachungsbereich nach Anspruch 1 beziehungsweise 14 gelöst. Der Sensor umfasst einen Lichtsender und einen Lichtempfänger, wobei der Lichtempfänger eine Vielzahl von Lichtempfangselementen oder Pixel aufweist, vorzugsweise in einer Zeile, aber auch in anderen Anordnungen wie einer Mehrfachzeile oder Matrix. Aus den Empfangssignalen der Lichtempfangselemente wird ein Schaltsignal erzeugt, wenn ein Objekt erfasst ist. Alternativ werden mehrere Schaltsignale aus mehreren Pixelgruppen des Lichtempfängers erzeugt.

Die Erfindung geht von dem Grundgedanken aus, die Funktionalität einer Schaltsignalerzeugung mit einer Erfassung der Lichtverteilung zu kombinieren. Dazu erzeugt eine Lichtverteilungsmesseinheit aus den Empfangssignalen zumindest einiger, vorzugsweise aller Lichtempfangselemente ein ortsaufgelöstes Lichtverteilungssignal. Das ist letztlich die Funktion der Intensität oder des Empfangspegels in Abhängigkeit vom Ort auf dem Lichtempfänger, insbesondere ein Empfangspegel je Lichtempfangselement oder Pixel. Daraus kann in weiteren Auswertungsschritten unter anderem die Position des Lichtflecks, dessen Breite, eine durchschnittliche Intensität und ähnliche Messinformation ermittelt werden. Dabei laufen die Auswertungen für das Schaltsignal und das Lichtverteilungssignal parallel nebeneinander oder simultan. Insbesondere steht ständig mit unverminderter Rate oder Geschwindigkeit ein aktuelles Schaltsignal zur Verfügung, obwohl parallel auch das Lichtverteilungssignal erzeugt wird.

Die Erfindung hat den Vorteil, dass die Vorteile eines schnellen schaltenden Sensors mit der robusten Bestimmung einer Lichtverteilung in einem Gerät miteinander kombiniert werden. Anders ausgedrückt erfolgen zugleich eine Objekt- oder Kantendetektion mit unvermindert hoher Schaltfrequenz und eine regelmäßig vergleichsweise langsame Messung der Lichtverteilung. Gegenüber einem nur schaltenden Sensor wird synchron zu einem robust und schnell bereitgestellten Schaltsignal die Information über die Energieverteilung auf dem Lichtempfänger für Mess-, Einstell- und Diagnosezwecke gewonnen. Dabei ist nur wenig zusätzlicher Aufwand erforderlich. Es werden dieselben optischen und signalerzeugenden Komponenten verwendet, lediglich die Auswertungsfunktionalität ist erweitert.

Vorzugsweise bilden Lichtsender und Lichtempfänger eine Triangulationsanordnung, sind also gemäß dem Triangulationsprinzip so zueinander angeordnet und ausgerichtet, dass das ausgesandte, im Überwachungsbereich reflektierte oder remittierte und wieder empfangene Licht auf dem Lichtempfänger eine vom Abstand des jeweils angetasteten Objekts abhängige Ablage hat. Dabei erzeugt vorzugsweise die Schaltsignaleinheit ein Schaltsignal nach dem Prinzip eines hintergrundausblendenden Tasters. Das bedeutet, dass je nach Anwesenheit eines Objekts geschaltet wird, jedoch beschränkt auf einen bestimmten Entfernungsbereich durch Ausblenden von Empfangssignalen von Objekten außerhalb dieses Entfernungsbereichs als Hintergrundsignal. Das Prinzip der Hintergrundausblendung beziehungsweise eines hintergrundausblendenden Tasters wurde einleitend erläutert. Hierdurch wird die Funktionalität einer Schaltsignalerzeugung bei Hintergrundausblendung um eine triangulationsbasierte Entfernungsmessung (Displacement) erweitert, oder anders ausgedrückt ein Reflexions-Lichttaster mit Hintergrundausblendung und ein Abstands- oder Displacement-Messsensors im selben Sensor verwirklicht.

Vorzugsweise ist die Lichtverteilungsmesseinheit als Abstandsmesseinheit dafür ausgebildet, aus dem Lichtverteilungssignal einen Abstand zu bestimmen. Dabei wird die Ablage des Lichtflecks aus dem Lichtverteilungssignal erfasst und daraus nach dem Triangulationsprinzip ein präziser Messwert für den Abstand des angetasteten Objekts ermittelt. Der Abstand kann aus einem Schwerpunkt, Median oder einer vergleichbaren Größe für die Positionsbestimmung des Empfangslichtflecks über eine triangulationsbasierte Umrechnung zwischen Lage auf dem Lichtempfänger und Objektdistanz bestimmt werden. Die Zuordnung zu der Lichtverteilungsmesseinheit ist zunächst rein funktional, eine örtlich oder logisch direkt verbundene reale Implementierung nur vorteilhaft, aber nicht zwingend. Letztlich ist für den Sensor belanglos, an welcher Stelle diese Auswertung konkret stattfindet.

Die Schaltsignaleinheit ist bevorzugt dafür ausgebildet, einen Trennsteg zwischen Lichtempfangselementen für nahe Objekte und Lichtempfangselementen für ferne Objekte anhand des Lichtverteilungssignals festzulegen, insbesondere anhand eines daraus bestimmten Abstands. Dabei sind nahe Objekte solche, bei deren Erfassung geschaltet werden soll, während ferne Objekte lediglich auszublendenden Hintergrund darstellen. Da der Sensor selbst Entfernungen messen kann, ist es sehr einfach, den Trennsteg durch Präsentieren eines Objekts in der gewünschten Entfernung einzulernen. Außerdem kann der Sensor jeweils eine Entfernung zu Hintergrund und Objekt messen und den Trennsteg dazwischen legen. Das ist sogar zum Nachführen im Betrieb denkbar.

Vorzugsweise ist der Schaltsignaleinheit zumindest ein Nahbereichssignal aus zusammengefassten Empfangssignalen von Lichtempfangselementen, die Licht von Objekten in nahem Abstand empfangen, und ein Fernbereichssignal aus zusammengefassten Empfangssignalen von Lichtempfangselementen zugeführt, die Licht von Objekten in fernem Abstand empfangen, wobei die Schaltsignaleinheit dafür ausgebildet ist, zur Erzeugung des Schaltsignals die Differenz zwischen dem Nahbereichssignal und dem Fernbereichssignal mit einer Schwelle zu bewerten. Dies ist ein konkretes Verfahren zur Schaltsignalerzeugung nach dem Prinzip eines hintergrundausblendenden Lichttasters. Die Bezeichnungen nah und fern sind nur relativ zu verstehen, ein bestimmter absoluter Abstand kann in einer Anwendung nah und in einer anderen Anwendung fern sein. Da der Empfangslichtfleck nach dem Triangulationsprinzip mit verändertem Abstand über den Lichtempfänger wandert, entspricht der Übergang zwischen Nahbereich und Fernbereich im Überwachungsbereich einer Position auf dem Lichtempfänger, wo der Übergang auch Trennsteg genannt wird. Wie schon einleitend erwähnt, kann der Trennsteg mechanisch oder elektronisch verstellbar sein. Dabei kann der Trennsteg auf der Grenze zwischen zwei physischen Pixeln liegen, es gibt aber auch Möglichkeiten, ihn subpixelgenau zu definieren.

Der Sensor weist bevorzugt eine zweite Vielzahl von Verarbeitungskanälen für Empfangssignale der Lichtempfangselemente auf, wobei die zweite Vielzahl kleiner ist als die erste Vielzahl. Damit teilen sich jeweils mehrere Lichtempfangselemente eine analoge und digitale Signalauswertung, um Kosten und Platzbedarf zu begrenzen. Insbesondere eine aufwändige Signalaufbereitung wäre wirtschaftlich für jedes Pixel separat nur schwer zu leisten. Vorzugsweise ist die zweite Vielzahl sogar deutlich kleiner als die erste Vielzahl. Dann stehen einer Größenordnung von hundert oder sogar noch deutlich mehr Lichtempfangselementen nur einige, höchstens zehn Verarbeitungskanäle gegenüber. Bevorzugte Ausführungsformen kommen mit drei oder vier Verarbeitungskanälen aus.

Vorzugsweise durchläuft das Nahbereichssignal mindestens einen Nah-Verarbeitungskanal und das Fernbereichssignal mindestens einen Fern-Verarbeitungskanal. Somit sind zwei Verarbeitungskanäle speziell dem Nah- und Fernbereich für eine Hintergrundausblendung zugeordnet. Die Verteilung von Nah- beziehungsweise Fernbereichssignal auf jeweils mehrere Verarbeitungskanäle ist aber denkbar und kann zu einer günstigeren Aussteuerung und einem verbesserten Rauschverhalten bei einer A/D-Wandlung führen. Das wird aber sprachlich im Weiteren nicht unterschieden, wo stets stellvertretend nur jeweils ein Nah- und Fern-Verarbeitungskanal genannt wird.

Das Empfangssignal eines Lichtempfangselements am Trennsteg zwischen Lichtempfangselementen für das Nahbereichssignal und Lichtempfangselementen für das Fernbereichssignal durchläuft bevorzugt einen Sub-Verarbeitungskanal, und die Schaltsignaleinheit fügt das Signal des Sub-Verarbeitungskanals für eine Subpixelauflösung anteilig dem Nahbereichssignal und dem Fernbereichssignal hinzu. Das ist eine Möglichkeit, die oben schon angesprochene Subpixelauflösung zu erreichen. Der Trennsteg ist nicht mehr auf physische Grenzen zwischen Lichtempfangselementen angewiesen. Der Anteil ist beispielsweise ein Faktor, der bei der Einstellung des Schaltabstands beziehungsweise der Lage des Trennstegs etwa in einem Einlernschritt festgelegt wird. Dann wird ein entsprechender Anteil des Sub-Verarbeitungskanals dem Nahbereich beziehungsweise dem Fernbereich hinzugefügt. Ein Pixel an der Grenze zwischen Nah- und Fernbereich ist somit effektiv an einer gewünschten subpixelgenauen Trennstegposition durchgeteilt.

Die Empfangssignale mindestens eines Lichtempfangselements durchlaufen bevorzugt einen Mess-Verarbeitungskanal, wobei die Lichtverteilungsmesseinheit das Lichtverteilungssignal aus dem Signal des Mess-Verarbeitungskanals erzeugt. Somit gibt es einen eigenen Verarbeitungskanal für die Entfernungsmessung.

Das mindestens eine Lichtempfangselement, welches den Mess-Verarbeitungskanal durchläuft, wechselt bevorzugt zyklisch, um so das Lichtverteilungssignal nach und nach aufzubauen. Auf diese Weise wird durch eine Art Abscannen des Lichtempfangselements die gewünschte Ortsauflösung erreicht. Der Wechsel findet bevorzugt im Rahmen von Messwiederholungen statt, in denen beispielsweise ein Sendepuls mit einer Messwiederholfrequenz ausgesandt wird. Solche raschen Messwiederholungen sind in vielen Ausführungsformen für eine hohe Schaltfrequenz ohnehin vorgesehen. Das jeweilige Ergebnis, also das Signal des Mess-Verarbeitungskanals, kann in einem Zwischenspeicher oder Register gespeichert werden, in dem sich im Verlauf des Zyklus' ein aktuelles Lichtverteilungssignal bildet. Vorzugsweise wird dem Mess-Verarbeitungskanal jeweils das Empfangssignal nur eines Lichtempfangselements zugeführt, weil sich damit die höchste Ortsauflösung ergibt, und der Zyklus durchläuft alle Lichtempfangselemente. Von beiden Bedingungen kann auch abgewichen werden. Beispielweise werden j > 1 Lichtempfangselemente zugleich dem Mess-Verarbeitungskanal zugeführt, mit entsprechendem Verlust an Ortsauflösung, oder es wird in einer Art verschachtelter Verarbeitung beim Wechsel trotz j > 1 nur um jeweils 1 < k < j Lichtempfangselemente weitergeschoben. Der Zyklus kann einen Teil der Lichtempfangselemente auslassen, womit effektiv die Messung auf einen gewissen Teilbereich der möglichen Entfernungen beschränkt wird.

Noch bevorzugter ist der Mess-Verarbeitungskanal auch mit der Schaltsignaleinheit verbunden. Das mindestens eine Lichtempfangselement, dessen Empfangssignal den Mess-Verarbeitungskanal durchläuft, kann dann dort auch so berücksichtigt werden, als hätte es den Fern-, Nah- oder Sub-Verarbeitungskanal mit durchlaufen. Damit kann die Schaltsignalerzeugung so erfolgen, als gäbe es keinen Mess-Verarbeitungskanal, da der Schaltsignaleinheit die Empfangssignale sämtlicher Lichtempfangselemente in richtiger Zuordnung weiterhin zur Verfügung stehen. Aus Sicht der Schaltsignaleinheit arbeitet der Mess-Verarbeitungskanal wie ein dynamisch wechselnder, d.h. mit unterschiedlichen Lichtempfangselementen verbundener Unterkanal des Nah-, Fern- oder Subverarbeitungskanals.

Die Verarbeitungskanäle sind bevorzugt für eine analoge und/oder digitale Signalaufbereitung der Empfangssignale ausgebildet, insbesondere mit einem Verstärker, einem Filter für Gleichlichtanteile, einem A/D-Wandler, einem Glättungsfilter und/oder einem Frequenzfilter. Dadurch wird eine erheblich robustere Erfassung ermöglicht. Da es nur vergleichsweise wenige Verarbeitungskanäle gibt, kann ohne allzu großen Aufwand auch mit komplexeren Bausteinen gearbeitet werden. Eine beispielhafte Signalverarbeitung sieht im Analogteil eine Verstärkung, ein Herausfiltern des Gleichlichtanteils (DC) und nach A/D-Wandlung weitere digitale Filter wie einen FIR-Filter vor. Somit wird die hohe Geschwindigkeit der Erzeugung eines Schaltsignals mit einer hohen Robustheit verbunden.

Das Glättungsfilter und/oder Frequenzfilter ist bevorzugt ein FIR-Filter mindestens der zweiten Ordnung, also der Ordnung m≥2. Das bedeutet, dass das FIR-Filter mindestens 2+1=3 Stützstellen hat und beispielsweise im einfachsten Fall ein O-S-O (Hintergrund-Signal-Hintergrund)-Verfahren ist. In höheren Ordnungen kann die Alternierung O-S-O-S-O... fortgesetzt werden. Die Stützstellen im Signal gewinnt man insbesondere durch wiederholtes Aussenden eines Lichtpulses und Abtasten des zugehörigen Empfangssignals, die Stützstellen im Hintergrund durch Zwischenabtastungen. Es können auch zwei oder mehr Filter parallel zueinander arbeiten, die das Signal auf unterschiedliche Weise befiltern.

Der Sensor weist bevorzugt eine Multiplexeinheit zum Verbinden der Lichtempfangselemente mit jeweils einem Verarbeitungskanal auf. Damit lässt sich zuordnen, welches Lichtempfangselement zu welchem Verarbeitungskanal gehört. So lässt sich der Trennsteg einstellen und verändern, indem Lichtempfangselemente mit einem Nah- und Fern- sowie gegebenenfalls einem Sub-Verarbeitungskanal verbunden werden. Die Multiplexeinheit ist noch bevorzugter programmierbar, um die Zuordnungen einfach verändern zu können.

Der Sensor weist bevorzugt einen Schaltausgang zur Ausgabe des Schaltsignals und eine Schnittstelle zur Ausgabe des Lichtverteilungssignals und/oder einer darauf abgeleiteten Messgröße auf. Der Schaltausgang kann mit hoher Schaltfrequenz das binäre Ergebnis der Objekt- oder Kantendetektion ausgeben. Zugleich ist über die analoge oder digitale Schnittstelle eine meist langsamere Übermittlung des Lichtverteilungssignals oder einer daraus abgeleiteten Größe möglich. Dabei steht ein aktuelles Schaltsignal auch parallel zu einem langsameren Messvorgang für ein Lichtverteilungssignal bereit, insbesondere zu jeder Messwiederholung.

Die Lichtverteilungsmesseinheit ist bevorzugt dafür ausgebildet, aus dem Lichtverteilungssignal einen Pegel, einen Remissionswert und/oder eine Lichtfleckbreite zu bestimmen. Eine solche vorzugsweise kontinuierliche Auswertung ergibt Messgrößen, die für den Anwender meist interessanter sind als das Lichtverteilungssignal selbst, das ja zunächst nur eine Intensitätsverteilung über den Lichtempfänger darstellt. Die Summe oder das Integral des Lichtverteilungssignals ist ein Maß für den Gesamtpegel und dieses wiederum bei in einer Triangulationsanordnung bekanntem oder bestimmbarem Abstand ein Maß für die Objektremission. Die Lichtfleckbreite wird bei einem glänzenden Objekt mit gerichteter Reflexion deutlich geringer sein, so dass sich hieraus Aussagen über das Glanzverhalten ableiten lassen. Die Symmetrie der Lichtverteilung enthält Informationen über den Objektkontrast.

Die Lichtverteilungsmesseinheit ist bevorzugt dafür ausgebildet, je nach Schaltsignal ein erstes Lichtverteilungssignal für den Vordergrund oder ein zweites Lichtverteilungssignal für den Hintergrund zu bestimmen. Konkret werden Empfangssignale der Lichtempfangselemente, insbesondere derjenigen des Mess-Verarbeitungskanals, je nach aktuellem Schaltzustand nur für das zugehörige Lichtverteilungssignal genutzt. Dazu können zwei unterschiedliche Zwischenspeicher oder Register für die beiden Lichtverteilungssignale vorgesehen sein. Das Ergebnis sind Lichtverteilungssignale oder ortsaufgelöste Lichtverteilungen getrennt in Anwesenheit eines Objektes beziehungsweise für den Vordergrund und in Abwesenheit eines Objektes beziehungsweise für den Hintergrund.

Besonders bevorzugt wird für die beiden Lichtverteilungssignale nochmals jeweils in ein aktives und ein inaktives Lichtverteilungssignal unterschieden. Sollte nämlich während der Bestimmung des aktiven Lichtverteilungssignals das Schaltsignal seinen Zustand wechseln, so ergibt sich ein gemischtes Messergebnis aus Vorder- und Hintergrund, das nicht ausreichend verlässlich sein kann. Folglich wird es nach dieser Ausführungsform verworfen und weiterhin das zugehörige inaktive Lichtverteilungssignal aus einer früheren vollständigen Erfassung für nachgelagerte Auswertungen und Ausgaben verwendet. Wird ein aktives Lichtverteilungssignal vollständig erfasst, dient es auch als das künftige inaktive Lichtverteilungssignal.

Der Sensor weist bevorzugt eine zweite, diffuse Lichtquelle auf, wobei die Lichtverteilungsmesseinheit dafür ausgebildet ist, unter diffuser Beleuchtung ein Lichtverteilungssignal des Hintergrundes aufzunehmen, um damit spätere Messungen zu kompensieren. Damit können insbesondere glänzende Objekte oder Flächen im Hintergrund aufgespürt werden. Die Lichtempfangselemente, in denen auch im Betrieb von dort ein störender Reflex droht, können in der Auswertung mit entsprechender Dämpfung berücksichtigt werden.

Das erfindungsgemäße Verfahren kann auf ähnliche Weise weitergebildet werden und zeigt dabei ähnliche Vorteile. Derartige vorteilhafte Merkmale sind beispielhaft, aber nicht abschließend in den sich an die unabhängigen Ansprüche anschließenden Unteransprüchen beschrieben.

Die Erfindung wird nachstehend auch hinsichtlich weiterer Merkmale und Vorteile beispielhaft anhand von Ausführungsformen und unter Bezug auf die beigefügte Zeichnung näher erläutert. Die Abbildungen der Zeichnung zeigen in:
- Fig. 1: eine schematische Schnittdarstellung eines optoelektronischen Sensors in Triangulationsanordnung;
- Fig. 2: eine schematische Ansicht eines pixelaufgelösten Lichtempfängers zur Erläuterung der Aufteilung auf Verarbeitungskanäle für eine Hintergrundausblendung;
- Fig. 3: eine schematische Ansicht des pixelaufgelösten Lichtempfängers gemäß Figur 3, jedoch mit Erläuterung der Zuordnung zu einem Mess-Verarbeitungskanal zur Entfernungsmessung; und
- Fig. 4: ein Blockschaubild einer Auswertung zur parallelen Schaltsignalerzeugung und Abstandsbestimmung.

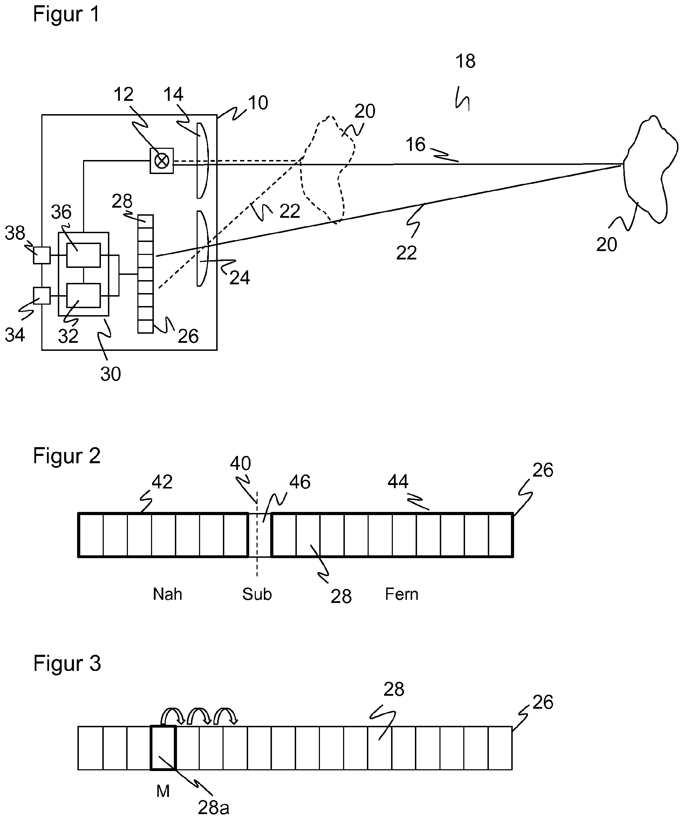

Figur 1 zeigt eine schematische Schnittdarstellung eines Sensors 10 in Triangulationsanordnung. Ein typisches, aber nicht einschränkendes Anwendungsbeispiel ist die schnelle Objekt- und Kantendetektion bei seitlich einfahrenden Objekten beispielsweise an einem Förderband. Die Erfindung wird zunächst an einem Sensor 10 in Triangulationsanordnung und erst im Anschluss an anderen Ausführungsformen erläutert.

Ein Lichtsender 12 sendet über einer strahlformenden Sendeoptik 14 einen Lichtstrahl 16 in einen Überwachungsbereich 18 aus. Fällt der Lichtstrahl 16 auf ein Objekt 20, so gelangt ein Teil des Sendelichts als remittierter oder reflektierter Lichtstrahl 22 zurück zu dem Sensor 10. Eine Empfangsoptik 24 fängt diesen remittierten Lichtstrahl 22 auf und leitet ihn auf einen Lichtempfänger 26, wo das einfallende Licht in ein elektrisches Empfangssignal umgewandelt wird. Der Lichtempfänger 26 weist eine Vielzahl von Pixeln oder Lichtempfangselementen 28 auf, insbesondere Photodioden. Die Lichtempfangselemente 28 bilden eine Zeilenanordnung, können in anderen Ausführungsformen aber auch zu einer Matrix oder noch anders angeordnet werden.

Aufgrund der Triangulationsanordnung, in der Ausführungsform nach Figur 1 des Versatzes zwischen Lichtsender 12 mit Sendeoptik 14 gegenüber dem Lichtempfänger 26 mit Empfangsoptik 24 und wegen der Anordnung der Lichtempfangselemente 28 längs der Querverbindung zwischen Lichtsender 12 und Lichtempfänger 26 fällt der remittierte Lichtstrahl 22 eines mit gestrichelten Linien dargestellten nahen Objekts 20 auf andere Lichtempfangselemente 28, in Figur 1 weiter oben, als der remittierte Lichtstrahl 22 eines mit durchgezogenen Linien dargestellten fernen Objekts 20. Die Position des Empfangslichtflecks, auch dessen Ablage, Offset oder Displacement genannt, die sich darin niederschlägt, welches oder welche der Lichtempfangselemente 28 den Empfangslichtfleck erfasst, ist daher ein Maß für den Abstand des Objekts 20.

Eine Auswertungseinheit 30 ist mit dem Lichtsender 12 zu dessen Ansteuerung und mit dem Lichtempfänger 26 verbunden, um die elektrischen Empfangssignale der Lichtempfangselemente 28 weiter auszuwerten. Dabei wird in einer Schaltsignaleinheit 32 je nach Anwesenheit eines Objekts 20 unter Hintergrundausblendung ein Objektfeststellungssignal bestimmt und an einem Schaltausgang 34 ausgegeben. Parallel dazu wird in einer Lichtverteilungsmesseinheit 36, die hier insbesondere als Abstandsmesseinheit ausgebildet sein kann, ein Lichtverteilungssignal gemessen, welches die Verteilung der Intensität über die Lichtempfangselemente 28 erfasst. Das Lichtverteilungssignal oder eine daraus abgeleitete Messgröße wird an einer Schnittstelle 38 ausgegeben. Ausführungsformen der Auswertung werden nachfolgend näher erläutert.

Figur 2 zeigt eine schematische Draufsicht des Lichtempfängers 26. Gegenüber der Figur 1 ist der Lichtempfänger 26 aus der Papierebene heraus und zudem innerhalb der Papierebene um 90° mit dem Uhrzeigersinn gedreht. Für eine Hintergrundausblendung wird ein Trennsteg 40 zwischen einem Nah- und einem Fernbereich definiert. Die Lichtempfangselemente 28 links davon werden einem Nahbereich 42, die Lichtempfangselemente 28 rechts davon einem Fernbereich 44 zugeordnet. Das Lichtempfangselement 28 am Übergang 46 mit dem Trennsteg 40 kann gesondert behandelt werden, um den Trennsteg 40 subpixelgenau zu definieren. Alternativ kann der Trennsteg 40 nur auf Grenzen zwischen Lichtempfangselemente 28 gelegt werden.

Figur 3 zeigt eine weitere schematische Draufsicht des Lichtempfängers 26. Dabei handelt es sich jeweils um denselben Lichtempfänger 26 lediglich in einer Betrachtung in einem anderen Kontext. Die Zuordnung zu bestimmten Gruppen oder Bereichen betrifft nicht den Lichtempfänger 26 selbst, sondern die nachgelagerte Signalverarbeitung und Auswertung. Während Figur 2 die Hintergrundausblendung illustriert, dient Figur 3 der Erläuterung einer Abstandsmessung. Dazu wird jeweils ein Lichtempfangselement 28a ausgewählt und ausgelesen. Alternativ kann unter Verlust von Ortsauflösung auch eine größere Gruppe von j > 1 Lichtempfangselementen ausgewählt werden. Mit jeder Messwiederholung oder jeder Signalauslesung wird die Auswahl verschoben, wie durch Pfeile angedeutet. So entsteht nach und nach das Lichtverteilungs- oder Abstandsbestimmungssignal der ortsaufgelösten Intensität aller sukzessive ausgewählten Lichtempfangselemente 28a. Vorzugsweise umfasst ein solcher Zyklus alle Lichtempfangselemente 28, aber eine Teilauswahl und damit elektronische Entfernungsbereichsauswahl ist auch denkbar. Somit ist für eine Erfassung eines Lichtverteilungssignals eine Art Abscannen des Lichtempfängers 26 erforderlich, die vergleichsweise langsam ist. Die Schaltsignalerzeugung nach Figur 2 dagegen liefert mit jedem Ausleseschritt ein aktuelles Schaltsignal.

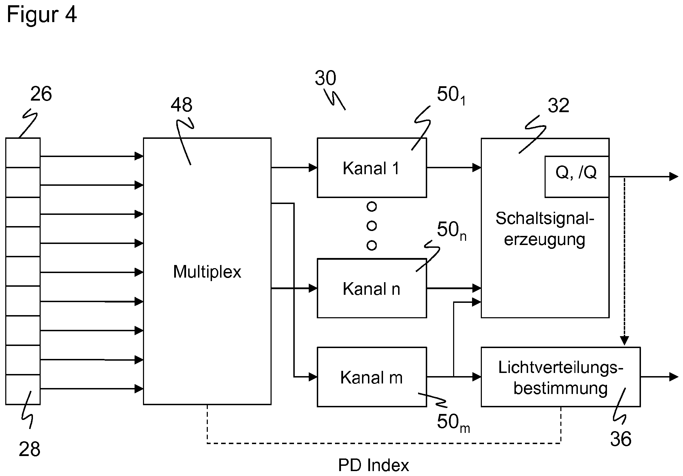

Figur 4 zeigt ein Blockschaltbild einer Ausführungsform der Auswertungseinheit 30. Die Auswertungseinheit weist außer der schon erwähnten Schaltsignaleinheit 32 und Lichtverteilungsmesseinheit 36 eine Multiplexeinheit 48 und mehrere Verarbeitungskanäle 50₁...50ₙ, 50ₘ auf. Die Multiplexeinheit 48 ist eingangsseitig mit den Lichtempfangselementen 28 und ausgangsseitig mit den Verarbeitungskanälen 50₁...50ₙ, 50ₘ verbunden. Die Ausgangssignale von n der Verarbeitungskanäle 50₁...50ₙ werden der Schalsignaleinheit 32, mindestens eines weiteren Verarbeitungskanals 50ₘ der Lichtverteilungsmesseinheit 36 und bevorzugt zusätzlich der Schaltsignaleinheit 32 zugeführt.

Die Multiplexeinheit 48, die beispielsweise eine Matrix aus programmierbaren Schaltern aufweist, bündelt jeweils Gruppen von Lichtempfangselementen 28 auf einen der Verarbeitungskanäle 50₁...50ₙ, 50ₘ. Dabei ist nicht ausgeschlossen, dass eine Gruppe aus nur einem Lichtempfangselement 28 besteht, und insbesondere für den weiteren Verarbeitungskanal ist das sogar bevorzugt der Fall. Die Flexibilität der Multiplexeinheit 48 dient hinsichtlich der Verarbeitungskanäle 50₁...50ₙ einer Einstellbarkeit des Trennstegs. Bei fixem Trennsteg oder mechanischer Verstellung ist hierfür ein Multiplexing nicht unbedingt erforderlich.

Die Verarbeitungskanäle 50₁...50ₙ, 50ₘ weisen vorzugsweise eine nicht dargestellte analoge und/oder digitale Signalaufbereitung auf. Dies dient unter anderem dazu, das durch Sonnenlicht und künstliche Lichtquellen erzeugte Umgebungslicht möglichst vollständig vom Nutzlicht zu trennen. Dazu können unterschiedliche Frequenzanteile mehrstufig elektronisch entfernt werden. Beispielsweise verursacht das Licht von LED-Lampen mit elektronischen Schaltnetzteilen Störsignale mit Frequenzanteile bis in den Bereich mehrere 100 kHz auf. Daher ist vorteilhaft, die Empfangssignale mit einer höheren Samplingrate von beispielsweise 1 MHz zu digitalisieren und dann diese Störfrequenzen mit einem digitalen Filter zu entfernen. Eine konkrete Umsetzung kann einen Filter zur Entfernung des niederfrequenten Fotodioden-Stroms (DC-Loop), einen Strom-Spannungs-Konverter (Transimpedanzverstärker, TIA), einen Analog-Digital-Konverter und ein Digitalfilter wie ein FIR-Filter vorsehen. Je nach Ausführungsform ist nur ein Teil dieser Elemente vorhanden.

Damit ist ein jeder der Verarbeitungskanäle 50₁...50ₙ, 50ₘ für sich in der Lage, ein sehr störlichtrobustes Ausgangssignal entsprechend den zugeführten Empfangssignalen der zugeordneten Lichtempfangselemente zu generieren. Ein herkömmliches Abstandsmesssystem mit individueller Analog-Digital-Wandlung für jedes einzelne Lichtempfangselement muss ohne vergleichbare Signalaufbereitung auskommen und ist wenig störrobust.

Als illustratives, aber nicht einschränkend zu verstehendes Zahlenbeispiel sind 128 Lichtempfangselemente 28 und drei Verarbeitungskanäle 50₁...50ₙ für die Schaltsignalerzeugung vorgesehen. Damit lässt sich eine Hintergrundausblendung mit subpixelgenau elektronisch einstellbarem Trennsteg 40 bei sehr hoher Auflösung, sehr guter Störsignal-Robustheit und hoher Schaltfrequenz darstellen. Alternativ wird auf einen Verarbeitungskanal 50₁...50ₙ und die Möglichkeit einer subpixelgenauen Einstellung des Trennstegs 40 verzichtet. Dann ist ein Verarbeitungskanal 50₁ dem Nah- und ein Verarbeitungskanal 50₂ dem Fernbereich zugeordnet. Es kann auch vorteilhaft sein, mit mehr Verarbeitungskanälen 50₁...50ₙ zu arbeiten, da dann die Energie des remittierten Sendelichtstrahls stärker verteilt wird, was unter Umständen zu einer günstigeren Aussteuerung beziehungsweise ein verbessertes Rauschverhalten der A/D-Wandler führt.

Mit Hilfe der Ausgangssignale aus den Verarbeitungskanälen 50₁...50ₙ erzeugt die Schaltsignaleinheit 32 durch geeignete arithmetische Verknüpfung und Bewertung ein Objektfeststellungssignal und stellt es am Schaltausgang 34 bereit. Dazu wird beispielsweise das Schaltsignal definiert als Q := ((N-F) > thresh), wobei N die Summe der einem Nahbereich zugeordneten Verarbeitungskanäle 50₁..50ₖ, F die Summe der einem Fernbereich zugeordneten Verarbeitungskanäle 50ₖ₊₁...50ₙ und thresh eine einstellbare Schwelle üblicherweise nahe Null ist, die eine Hysterese aufweisen kann. Das entspricht dem typischen Schaltsignal eines hintergrundausblendenden Tasters auf Basis von Triangulation.

Um den Trennsteg subpixelgenau festlegen zu können, oder anders ausgedrückt um eine höhere geometrische Auflösung des Schaltpunktes zu erhalten, wird ein zusätzlicher Verarbeitungskanal 50ᵢ verwendet, der mit genau einem Lichtempfangselement 28 am Übergang 46 zwischen Nah- und Fernbereich verbunden ist und der Subpixelinterpolation dient. Der Schaltzustand ergibt sich dann aus der modifizierten Gleichung Q := (N + a V - F > thresh). Dabei ist a ein Faktor zwischen 1 und -1, der bei der Einstellung des Schaltpunktes festgelegt wird, und V bezeichnet das Ausganssignal des zusätzlichen Verarbeitungskanals 50ᵢ.

Der mindestens eine weitere Verarbeitungskanal 50ₘ wird mit Hilfe der Multiplexeinheit 48 variabel einem der Lichtempfangselemente 28 zugeordnet. Dazu ist beispielsweise ein Zähler PD Index vorgesehen, welcher die Lichtempfangselemente 28 sukzessive in einem Zyklus durchläuft. Der jeweilige Wechsel kann an eine Messwiederholung gebunden sein. Dazu wird insbesondere mit einem Pulsgenerator, einer Stromquelle, einer LED oder Laserdiode des Lichtsenders 12 wiederholt ein Einzelpuls oder ein Paket von Lichtpulsen erzeugt. Bevorzugt läuft PD Index schrittweise durch alle benachbarten Lichtempfangselemente 28. Eine abweichende Reihenfolge, größere Schritte unter Auslassung von Lichtempfangselementen 28, eine Zuordnung von mehreren Lichtempfangselementen 28 zu dem weiteren Verarbeitungskanal 50ₘ und/oder eine Beschränkung auf einen Teilbereich der Lichtempfangselemente 28 ist aber denkbar.

Das Ausgangssignal des weiteren Verarbeitungskanals 50ₘ wird in der Lichtverteilungsmesseinheit 36 gespeichert, etwa in einem Register, und so sukzessive ein Lichtverteilungssignal aufgebaut. Zugleich kann das Ausgangssignal auch der Schaltsignaleinheit 32 zugeführt, und auf diese Weise gerade demjenigen der Verarbeitungskanäle 50₁...50ₙ zugeschlagen werden, beispielsweise durch Summation, zu dem das betreffende Lichtempfangselement 28 seiner Lage nach gehört. Dadurch bleibt die Schaltsignalerzeugung von der zusätzlichen Erfassung durch den weiteren Verarbeitungskanal 50ₘ und die Lichtverteilungs- oder Abstandsbestimmung völlig unberührt. Es hat diesbezüglich lediglich das Signal von jeweils einem der Lichtempfangselemente 28 nicht den üblichen Weg über einen Nah- oder Fernbereichskanal 50₁...50ₙ, sondern den Sonderweg über den weiteren Verarbeitungskanal 50ₘ genommen.

Auf diese Weise wird simultan und mit hoher Wiederholrate, nämlich insbesondere einmal je Messwiederholung oder Sendepuls, ein Schaltsignal hoher Robustheit generiert, das gegenüber einem herkömmlichen Reflexionstaster mit Hintergrundausblendung in Robustheit und Schaltfrequenz nichts einbüßt, und zusätzlich wird gleichzeitig, wenn auch mit geringerer Messrate, ein vollständiges Lichtverteilungssignal zusammengesetzt, das auf weitere Messgrößen hin ausgewertet werden kann. Insbesondere kann aus dieser digitalisierten Lichtfleckverteilung auf dem Lichtempfänger 26 die Position des Lichtflecks und damit die Entfernung zum Objekt 20 ermittelt werden. In anderen Ausführungsformen wird ein Schaltsignal nicht aus jedem Sendepuls, sondern aus einer logischen Verknüpfung mehrerer Messwiederholungen abgeleitet. Der weitere Verarbeitungskanal 50ₘ wertet parallel dazu vorzugsweise mit jeder Messwiederholung ein anderes Lichtempfangselement 28 aus, obwohl auch davon abgewichen werden kann.

In einer bevorzugten Ausführungsform werden die Daten für eine Schaltermatrix der Multiplexeinheit 48 über Schieberegister zur Verfügung gestellt. Ein erstes Schieberegister mit einer Breite von zwei Bit pro Pixel (für Nah, Subpixel, Fern oder "aus") legt die Schaltermatrix für die Schaltsignalerzeugung fest. Ein zweites Schieberegister mit einer Breite von 1 Bit pro Pixel legt fest, ob dieses Pixel mit dem Mess-Verarbeitungskanal oder so wie vom ersten Schieberegister vorgesehen verbunden ist. Vorzugsweise enthält das erste Schieberegister nur eine einzige '1' und sonst ,0'. Das erste Schieberegister muss nur einmal bei der Justage des Schaltpunktes beschrieben werden, das zweite Schieberegister wird pro Messwiederholung entsprechend dem Zähler PD Index weitergetaktet.

Es ist denkbar, dass sich während der Erfassung eines Lichtverteilungssignals der Objektabstand ändert. Dann würde über verschiedene Objektabstände gemittelt. In vielen Anwendungssituationen, nämlich wenn Objekte vor festem Hintergrund in festem Abstand seitlich ein- und vorbeifahren, treten immer nur zwei Objektabstände auf. Dafür kann in einer vorteilhaften Weiterbildung vorgesehen sein, zwei Lichtverteilungssignale zu unterscheiden, nämlich eines für den Vordergrund und eines für den Hintergrund, und dafür zwei Speicher oder Register in der Lichtverteilungsmesseinheit 36 vorzuhalten.

Das Ausgangssignal des weiteren Verarbeitungskanals 50ₘ wird dann je nach Schaltzustand dafür genutzt, das Lichtverteilungssignal für den Vordergrund oder für den Hintergrund zu erfassen. Ist kein Objekt erfasst, also Q=0, so wird das Lichtverteilungssignal für den Hintergrund erfasst, ist umgekehrt ein Objekt erfasst, also Q=1, so wird das Lichtverteilungssignal für den Vordergrund erfasst. Dann repräsentiert das Lichtverteilungssignal für den Hintergrund genau die Lichtverteilung für den Schaltzustand "Aus", also die Sicht auf den Hintergrund, und das Lichtverteilungssignal für den Vordergrund die Lichtverteilung für den Schaltzustand "Ein" und folglich die Sicht auf das Objekt.

Es ist noch denkbar, dass sich der Schaltzustand während der Erfassung eines Lichtverteilungssignals ändert. Dann bleibt das Lichtverteilungssignal unvollständig, beziehungsweise es würde wieder ungünstig gemittelt. Deshalb wird ein solches Lichtverteilungssignal, bei dem innerhalb eines definierten Zeitfensters ein Wechsel des Schaltausgangs erfolgt, vorzugsweise als inkonsistent verworfen. Um dennoch wenigstens nahezu aktuelle Lichtverteilungssignale verfügbar zu haben, kann es sinnvoll sein, die Speicher beziehungsweise Register für die Lichtverteilungssignale nochmals in aktiv und inaktiv zu doppeln. Für weitere Auswertungen und Ausgaben wird jeweils das Lichtverteilungssignal aus dem inaktiven Speicher verwendet. Sobald ein neues Lichtverteilungssignal ohne Wechsel des Schaltzustands bestimmt werden konnte, wird es in den inaktiven Speicher übertragen, beziehungsweise die Rollen der aktiven und inaktiven Speicher werden vertauscht.

Die Lichtverteilungsmesseinheit 36 kann das jeweilige Lichtverteilungssignal auch noch weiter auswerten, insbesondere kontinuierlich, und Auswertungsergebnisse an der Schnittstelle 38 bereitstellen oder anzeigen. Das betrifft zum einen eine Abstandsbestimmung, in welcher der Median oder eine andere, die Position des Empfangslichtflecks bezeichnenden Größe wie der Schwerpunkt des Lichtverteilungssignals ermittelt wird, um daraus mittels Triangulation den Objektabstand abzuleiten. Auch andere Messgrößen können interessant sein. Etwa ist die Summe oder das Integral des Lichtverteilungssignals ein Maß für die Objektremission, insbesondere in Kombination mit der Abstandsinformation. Aus der Breite der Lichtfleckverteilung in dem Lichtverteilungssignal lassen sich Aussagen über den Glanz der Objektoberfläche treffen, erneut insbesondere in Kombination mit der Abstandsinformation. Die Symmetrie kann als Maß für den Objektkontrast dienen.

In einer bevorzugten Weiterbildung wird das Ergebnis der Lichtverteilungsmesseinheit 36 genutzt, um die Schaltschwelle einzustellen. Dazu werden insbesondere die beiden Lichtverteilungssignale für Vordergrund und Hintergrund herangezogen, um den Trennsteg 40 optimal einzustellen. Das gilt sowohl für eine Einrichtphase (Teach-In) als auch für ein mögliches Nachführen im Betrieb.

In einer weiteren vorteilhaften Ausführungsform wird das Objekt 20 und seine Umgebung durch eine zweite, diffuse Lichtquelle beleuchtet. Das Lichtverteilungssignal enthält dann eine winkelverteilte Sicht auf den Hintergrund. Stark glänzende Hintergrundobjekte, wie reflektierende Metallflächen oder Schilder, welche eine Objekterfassung möglicherweise beeinträchtigen, erzeugen dann ein hohes Signal und können in einem nachfolgenden Bewertungsschritt oder Teachvorgang berücksichtigt werden, etwa durch Dämpfen oder gar Abschalten der betroffenen Lichtempfangselemente 28.

Die Erfindung wurde bisher an vielen Stellen im Rückgriff auf einen hintergrundausblendenden Taster erläutert. Sie ist aber darüber hinaus auch generell in anderen Sensoren einsetzbar, wie Lichtschnittsensoren, Lichtband-Sensoren oder Reflexionslichtschranken mit mehreren Auswertebereichen, die auf der Verwendung eines Lichtempfängers 26 mit einer Vielzahl von Lichtempfangselementen 28 basieren, sei es in einer Zeilen- oder auch einer Matrixanordnung. Dabei kann eine Triangulationsanordnung gewählt sein, aber die Erfindung ist darauf nicht beschränkt.

In einem solchen Sensor kann das Lichtverteilungssignal zur ein Schaltsignal ergänzenden Bewertung der vorliegenden Detektionssituation genutzt werden. Beispielsweise erzeugt ein glänzendes Objekt aufgrund seiner gerichteten Remissionscharakteristik einen oder mehrere kleinere Lichtflecke auf dem Lichtempfänger 26, die als Maxima in dem Lichtverteilungssignal erkennbar sind.

Wie einleitend kurz erwähnt, gibt es Sensoren, die auf ihrem Lichtempfänger 26 einen oder mehrere aktive Bereiche definieren. Beispielsweise wird ein solcher Sensor nur grob mechanisch ausgerichtet und dann eingelernt, wo sich der Empfangslichtfleck befindet, und die betreffenden Lichtempfangselemente 28 werden selektiert und gemeinsam für eine Objektfeststellung ausgewertet. Das funktioniert in gleicher Weise auch für mehrkanalige Systeme mit mehreren aktiven Bereichen und mehreren Schalt- oder Objektfeststellungssignalen. Das Lichtverteilungssignal liefert die notwendige Information, um die Bereiche festzulegen. Sie können sogar im laufenden Sensorbetrieb nachgeführt werden, beispielsweise um eine thermische Drift zu kompensieren.

Umgekehrt zur Anpassung aktiver Bereiche an einen Lichtfleck, der gemessen werden soll, kann es auch Ausblendungsbereiche geben. Diese wiederum können fix, um beispielsweise ein Transportband auszublenden, oder dynamisch etwa durch Störlicht gebildet sein. Das Lichtverteilungssignal erlaubt, solche Bereiche vorab und auch im laufenden Betrieb festzulegen, anzupassen und nachzuführen.

Eine weitere denkbare Auswertung des Lichtverteilungssignals betrifft eine Verschmutzung der Frontscheibe, die üblicherweise ein Sensorgehäuse im Bereich des Lichtdurchtritts abschließt. Zunehmende Verschmutzung führt zu mehr im Sensor reflektierten Streulicht und damit einem mehr oder weniger homogenen Anstieg des Signalpegels aller Lichtempfangselemente 28. Dies bildet gleichsam einen Rauschpegel, und daran kann die Verschmutzung erkannt und ein entsprechendes Warn- oder Wartungssignal ausgegeben werden.

## Patentansprüche

1. Optoelektronischer Sensor (10), der einen Lichtsender (12) zum Aussenden von Licht (16) in einen Überwachungsbereich (18), einen Lichtempfänger (26) mit einer ersten Vielzahl von Lichtempfangselementen (28) zum Empfangen des an Objekten (20) in dem Überwachungsbereich (18) reflektierten oder remittierten Lichts (22), eine Schaltsignaleinheit (32) zum Erzeugen eines Schaltsignals aus den Empfangssignalen der Lichtempfangselemente (28) sowie eine Lichtverteilungsmesseinheit (36) zum Erzeugen eines über zumindest einige der Lichtempfangselemente (28) ortsaufgelösten Lichtverteilungssignals aus den Empfangssignalen der Lichtempfangselemente (28) aufweist, wobei das ortsaufgelöste Lichtverteilungssignal die Funktion der Intensität oder des Empfangspegels in Abhängigkeit vom Ort auf dem Lichtempfänger (26) ist,
**dadurch gekennzeichnet,**
**dass** die Lichtverteilungsmesseinheit (36) das ortsaufgelöste Lichtverteilungssignal parallel zu dem Schaltsignal erzeugt und dass der Sensor (10) eine zweite Vielzahl von Verarbeitungskanälen (50₁...50ₙ, 50ₘ) für Empfangssignale der Lichtempfangselemente (28) aufweist, wobei die zweite Vielzahl kleiner ist als die erste Vielzahl und der optoelektronische Sensor (10) eine Multiplexeinheit (48) zum Verbinden der Lichtempfangselemente (28) mit jeweils einem Verarbeitungskanal (50₁...50ₙ, 50ₘ) aufweist.

2. Sensor (1) nach Anspruch 1,
wobei Lichtsender (12) und Lichtempfänger (26) eine Triangulationsanordnung bilden, wobei insbesondere die Schaltsignaleinheit (32) ein Schaltsignal nach dem Prinzip eines hintergrundausblendenden Tasters erzeugt.

3. Sensor (10) nach Anspruch 2,
wobei die Lichtverteilungsmesseinheit (36) als Abstandsmesseinheit dafür ausgebildet ist, aus dem Lichtverteilungssignal einen Abstand zu bestimmen.

4. Sensor nach Anspruch 2 oder 3,
wobei die Schaltsignaleinheit (32) dafür ausgebildet ist, einen Trennsteg (40) zwischen Lichtempfangselementen (28) für nahe Objekte und Lichtempfangselementen (28) für ferne Objekte anhand des Lichtverteilungssignals festzulegen, insbesondere anhand eines daraus bestimmten Abstands.

5. Sensor (10) nach einem der Ansprüche 2 bis 4,
wobei der Schaltsignaleinheit (32) zumindest ein Nahbereichssignal aus zusammengefassten Empfangssignalen von Lichtempfangselementen (28), die Licht (22) von Objekten (20) in nahem Abstand empfangen, und ein Fernbereichssignal aus zusammengefassten Empfangssignalen von Lichtempfangselementen (28) zugeführt ist, die Licht (22) von Objekten (28) in fernem Abstand empfangen, wobei die Schaltsignaleinheit (32) dafür ausgebildet ist, zur Erzeugung des Schaltsignals die Differenz zwischen dem Nahbereichs-signal und dem Fernbereichssignal mit einer Schwelle zu bewerten.

6. Sensor (10) nach Anspruch 5,
wobei das Nahbereichssignal mindestens einen Nah-Verarbeitungskanal (50₁...50ₙ) und das Fernbereichssignal mindestens einen Fern-Verarbeitungskanal (50₁...50ₙ) durchläuft, wobei insbesondere das Empfangssignal eines Lichtempfangselements (28) am Trennsteg (40) zwischen Lichtempfangs-elementen (28) für das Nahbereichssignal und Lichtempfangselementen (28) für das Fernbereichssignal einen Sub-Verarbeitungskanal (50ᵢ) durchläuft und die Schaltsignaleinheit (32) das Signal des Sub-Verarbeitungskanals (50ᵢ für eine Subpixelauflösung anteilig dem Nahbereichssignal und dem Fernbereichssignal hinzufügt.

7. Sensor (10) nach einem der vorhergehenden Ansprüche,
wobei die Empfangssignale mindestens eines Lichtempfangselements (28, 28a) einen Mess-Verarbeitungskanal (50ₘ) durchlaufen, und wobei die Lichtverteilungsmesseinheit (36) das Lichtverteilungssignal aus dem Signal des Mess-Verarbeitungskanals (50ₘ) erzeugt.

8. Sensor (10) nach Anspruch 7,
wobei das mindestens eine Lichtempfangselement (28, 28a), welches den Mess-Verarbeitungskanal (50ₘ) durchläuft, zyklisch wechselt, um so das Lichtverteilungssignal nach und nach aufzubauen, wobei insbesondere das Signal des Mess-Verarbeitungskanals (50ₘ) auch einem Verarbeitungskanal (50₁...50ₙ) für die Erzeugung des Schaltsignals hinzugefügt wird.

9. Sensor (10) nach einem der vorhergehenden Ansprüche,
wobei die Verarbeitungskanäle (50₁...50ₙ, 50ₘ) für eine analoge und/oder digitale Signalaufbereitung der Empfangssignale mit einem Filter für Gleichlichtanteile, einem A/D-Wandler, einem Glättungsfilter und/oder einem Frequenzfilter ausgebildet sind.

10. Sensor (10) nach Anspruch 9,
wobei das Glättungsfilter und/oder Frequenzfilter ein FIR-Filter mindestens der zweiten Ordnung aufweist.

11. Sensor (10) nach einem der vorhergehenden Ansprüche,
der einen Schaltausgang (34) zur Ausgabe des Schaltsignals und eine Schnittstelle (38) zur Ausgabe des Lichtverteilungssignals und/oder einer daraus abgeleiteten Messgröße aufweist, insbesondere eines Pegels, eines Remissionswertes und/oder einer Lichtfleckbreite.

12. Sensor (10) nach einem der vorhergehenden Ansprüche,
wobei die Lichtverteilungsmesseinheit (36) dafür ausgebildet ist, je nach Schaltsignal ein erstes Lichtverteilungssignal für den Vordergrund oder ein zweites Lichtverteilungssignal für den Hintergrund zu bestimmen und/oder der eine zweite, diffuse Lichtquelle aufweist, wobei die Lichtverteilungsmesseinheit (36) dafür ausgebildet ist, unter diffuser Beleuchtung ein Lichtverteilungssignal des Hintergrundes aufzunehmen, um damit spätere Messungen zu kompensieren.

13. Verfahren zum Erfassen von Objekten (20) in einem Überwachungsbereich (18), bei dem Licht (16) in den Überwachungsbereich (18) ausgesandt und nach Reflexion oder Remission an einem Objekt (20) mit einer Vielzahl von Lichtempfangselementen (28) wieder empfangen wird, wobei aus den Empfangssignalen der Lichtempfangselemente (28) ein Schaltsignal und ein über die Lichtempfangselemente (28) ortsaufgelöstes Lichtverteilungssignal erzeugt wird, wobei das ortsaufgelöste Lichtverteilungssignal die Funktion der Intensität oder des Empfangspegels in Abhängigkeit vom Ort auf dem Lichtempfänger (26) ist,
**dadurch gekennzeichnet,**
**dass** das ortsaufgelöste Lichtverteilungssignal parallel zum Erzeugen des Schaltsignals erzeugt wird und dass eine zweite Vielzahl von Verarbeitungskanälen (50₁...50ₙ, 50ₘ) für Empfangssignale der Lichtempfangselemente (28) vorgesehen ist, wobei die Lichtempfangselemente (28) mit jeweils einem Verarbeitungskanal (50₁...50ₙ, 50ₘ) mittels einer Multiplexeinheit (28) verbunden werden.

## Claims

1. An optoelectronic sensor (10) comprising a light transmitter (12) for transmitting light (16) into a monitored area (18), a light receiver (26) having a first plurality of light receiving elements (28) for receiving light (22) reflected or remitted from objects (20) in the monitored area (18), a switching signal unit (32) for generating a switching signal from the received signals of the light receiving elements (28) and a light distribution measuring unit (36) for generating a spatially resolved light distribution signal over at least some of the light receiving elements (28) from the received signals of the light receiving elements (28), wherein the spatially resolved light distribution signal is a function of the intensity or the reception level in dependence on the location on the light receiver (26), **characterized in that** the light distribution measuring unit (36) generates the spatially resolved light distribution signal in parallel with the switching signal, and **in that** the sensor (10) has a second plurality of processing channels (50₁...50ₙ, 50ₘ) for received signals from the light receiving elements (28), the second plurality being smaller than the first plurality, and the optoelectronic sensor (10) has a multiplexing unit (48) for connecting the light receiving elements (28) to a respective processing channel (50₁...50ₙ, 50ₘ).

2. The sensor (1) according to claim 1,
wherein light transmitter (12) and light receiver (26) form a triangulation arrangement, wherein in particular the switching signal unit (32) generates a switching signal according to the principle of a background suppression sensor.

3. The sensor (10) according to claim 2,
wherein the light distribution measuring unit (36) is configured as a distance measuring unit for determining a distance from the light distribution signal.

4. The sensor according to claim 2 or 3,
wherein the switching signal unit (32) is configured to determine a separating web (40) between light receiving elements (28) for near objects and light receiving elements (28) for far objects on the basis of the light distribution signal, in particular on the basis of a distance determined therefrom.

5. The sensor (10) according to one of claims 2 to 4,
wherein the switching signal unit (32) is fed at least one near-range signal from combined received signals of light receiving elements (28) which receive light (22) from objects (20) at a near distance, and a far-range signal from combined received signals of light receiving elements (28) which receive light (22) from objects (28) at a far distance, wherein the switching signal unit (32) is configured to evaluate the difference between the near-range signal and the far-range signal with a threshold in order to generate the switching signal.

6. The sensor (10) according to claim 5,
wherein the near range signal passes through at least one near processing channel (50₁...50ₙ) and the far range signal passes through at least one far processing channel (50₁...50ₙ), wherein in particular the received signal of a light receiving element (28) at the separating web (40) between light receiving elements (28) for the near range signal and light receiving elements (28) for the far range signal passes through a sub-processing channel (50ᵢ) and the switching signal unit (32) adds the signal of the sub-processing channel (50ᵢ) for a subpixel resolution proportionally to the near range signal and the far range signal.

7. The sensor (10) according to one of the previous claims,
wherein the received signals of at least one light receiving element (28, 28a) pass through a measurement processing channel (50ₘ), and wherein the light distribution measurement unit (36) generates the light distribution signal from the signal of the measurement processing channel (50ₘ).

8. The sensor (10) according to claim 7,
wherein the at least one light receiving element (28, 28a) which passes through the measurement processing channel (50ₘ) cyclically changes in order to iteratively build up the light distribution signal, wherein in particular the signal of the measurement processing channel (50ₘ) is also added to a processing channel (50₁...50ₙ) for generating the switching signal.

9. The sensor (10) according to one of the preceding claims,
wherein the processing channels (50₁...50ₙ, 50ₘ) are configured for analog and/or digital signal processing of the received signals with a filter for DC light components, an A/D converter, a smoothing filter and/or a frequency filter.

10. The sensor (10) according to claim 9,
wherein the smoothing filter and/or frequency filter comprises a FIR filter of at least the second order.

11. The sensor (10) according to one of the previous claims,
which has a switching output (34) for outputting the switching signal and an interface (38) for outputting the light distribution signal and/or a measured variable derived therefrom, in particular a level, a reflectance value and/or a light spot width.

12. The sensor (10) according to one of the previous claims,
wherein the light distribution measuring unit (36) is configured to determine a first light distribution signal for the foreground or a second light distribution signal for the background depending on the switching signal and/or wherein the sensor (10) comprises a second, diffuse light source, wherein the light distribution measuring unit (36) is adapted to receive a light distribution signal of the background under diffuse illumination for compensation in later measurements.

13. A method for detecting objects (20) in a monitored area (18), wherein light (16) is transmitted into the monitored area (18) and is received again with a plurality of light receiving elements (28) after reflection or remission at an object (20), a switching signal and a light distribution signal spatially resolved over the light receiving elements (28) being generated from the received signals of the light receiving elements (28), wherein the spatially resolved light distribution signal is a function of the intensity or the reception level in dependence on the location on the light receiver (26),
**characterized in that** the spatially resolved light distribution signal is generated in parallel with the generation of the switching signal, and **in that** a second plurality of processing channels (50₁...50ₙ, 50ₘ) is provided for received signals of the light receiving elements (28), wherein the light receiving elements (28) are each connected to a processing channel (50₁...50ₙ, 50ₘ) by means of a multiplexing unit (28).

## Revendications

1. Capteur optoélectronique (10) comportant un émetteur de lumière (12) pour émettre de la lumière (16) dans une zone à surveiller (18), un récepteur de lumière (26) ayant une première multitude d'éléments récepteurs de lumière (28) pour recevoir la lumière (22) réfléchie ou réémise sur des objets (20) situés dans la zone à surveiller (18), une unité de signal de commutation (32) pour générer un signal de commutation à partir des signaux de réception des éléments récepteurs de lumière (28) ainsi qu'une unité de mesure de la répartition de la lumière (36) pour générer un signal de répartition de lumière à résolution spatiale sur au moins quelques-uns des éléments récepteurs de lumière (28) à partir des signaux de réception des éléments récepteurs de lumière (28), le signal de répartition de lumière à résolution spatiale étant fonction de l'intensité ou du niveau de réception en dépendance de l'emplacement sur le récepteur de lumière (26),
**caractérisé en ce que**
l'unité de mesure de répartition de lumière (36) génère le signal de répartition de lumière à résolution spatiale en parallèle avec le signal de commutation, et **en ce que** le capteur (10) présente une deuxième multitude de canaux de traitement (50₁ ... 50ₙ, 50ₘ) pour des signaux de réception des éléments récepteurs de lumière (28), la deuxième multitude étant plus petite que la première multitude, et le capteur optoélectronique (10) comprend une unité de multiplexage (48) pour connecter les éléments récepteurs de lumière (28) à un canal de traitement respectif (50₁ ... 50ₙ, 50ₘ).

2. Capteur (1) selon la revendication 1,
dans lequel l'émetteur de lumière (12) et le récepteur de lumière (26) forment un ensemble de triangulation, et en particulier l'unité de signal de commutation (32) génère un signal de commutation selon le principe d'un capteur à suppression d'arrière-plan.

3. Capteur (10) selon la revendication 2,
dans lequel l'unité de mesure de répartition de lumière (36) à titre d'unité de mesure de distance est réalisée pour déterminer une distance à partir du signal de répartition de lumière.

4. Capteur selon la revendication 2 ou 3,
dans lequel l'unité de signal de commutation (32) est réalisée pour fixer une bande de séparation (40) entre des éléments récepteurs de lumière (28) pour des objets proches et des éléments récepteurs de lumière (28) pour des objets lointains sur la base du signal de répartition de lumière, en particulier sur la base d'une distance déterminée à partir de celui-ci.

5. Capteur (10) selon l'une des revendications 2 à 4,
dans lequel au moins un signal de zone proche comprenant des signaux de réception combinés provenant d'éléments récepteurs de lumière (28) qui reçoivent la lumière (22) d'objets (20) situés à une distance proche, et un signal de zone lointaine comprenant des signaux de réception combinés provenant d'éléments récepteurs de lumière (28) qui reçoivent la lumière (22) d'objets (28) situés à une distance lointaine, sont envoyés à l'unité de signal de commutation (32), l'unité de signal de commutation (32) étant réalisée pour évaluer avec un seuil la différence entre le signal de zone proche et le signal de zone lointaine, afin de générer le signal de commutation.

6. Capteur (10) selon la revendication 5,
dans lequel le signal de zone proche passe par au moins un canal de traitement de zone proche (50₁ ... 50ₙ), et le signal de zone lointaine passe par au moins un canal de traitement de zone lointaine (50₁ ... 50ₙ), et en particulier le signal de réception d'un élément récepteur de lumière (28) au niveau de la bande de séparation (40) entre les éléments récepteurs de lumière (28) pour le signal de zone proche et les éléments récepteurs de lumière (28) pour le signal de zone lointaine passe par un sous-canal de traitement (50ᵢ), et l'unité de signal de commutation (32) ajoute le signal du sous-canal de traitement (50ᵢ) proportionnellement au signal de zone proche et au signal de zone lointaine en vue d'une résolution sous-pixel.

7. Capteur (10) selon l'une des revendications précédentes,
dans lequel les signaux de réception d'au moins un élément récepteur de lumière (28, 28a) passent par un canal de traitement de mesure (50ₘ), et l'unité de mesure de répartition de lumière (36) génère le signal de répartition de lumière à partir du signal du canal de traitement de mesure (50ₘ).

8. Capteur (10) selon la revendication 7,
dans lequel ledit au moins un élément récepteur de lumière (28, 28a) qui passe par le canal de traitement de mesure (50ₘ) change de manière cyclique afin de construire progressivement le signal de répartition de lumière, et en particulier le signal du canal de traitement de mesure (50ₘ) est ajouté également à un canal de traitement (50₁ ... 50ₙ) pour la génération du signal de commutation.

9. Capteur (10) selon l'une des revendications précédentes,
dans lequel en vue d'un traitement analogique et/ou numérique des signaux de réception, les canaux de traitement (50₁ ... 50ₙ, 50ₘ) sont réalisés avec un filtre pour les composantes des lumière constante, un convertisseur A/N, un filtre de lissage et/ou avec un filtre de fréquence.

10. Capteur (10) selon la revendication 9,
dans lequel le filtre de lissage et/ou le filtre de fréquence comprend un filtre RIF au moins du deuxième ordre.

11. Capteur (10) selon l'une des revendications précédentes,
comportant une sortie de commutation (34) pour sortir le signal de commutation et une interface (38) pour sortir le signal de répartition de lumière et/ou une grandeur de mesure qui en découle, en particulier un niveau, une valeur de réémission et/ou une largeur de spot lumineux.

12. Capteur (10) selon l'une des revendications précédentes,
dans lequel l'unité de mesure de répartition de lumière (36) est réalisée pour déterminer un premier signal de répartition de lumière pour l'avant-plan ou un second signal de répartition de lumière pour l'arrière-plan, en fonction du signal de commutation, et/ou ledit capteur comporte une seconde source de lumière diffuse, l'unité de mesure de répartition de lumière (36) étant réalisée pour enregistrer un signal de répartition de lumière de l'arrière-plan sous un éclairage diffus afin de compenser des mesures ultérieures.

13. Procédé de détection d'objets (20) dans une zone à surveiller (18),
dans lequel de la lumière (16) est émise dans la zone à surveiller (18) et est reçue après réflexion ou réémission sur un objet (20) au moyen d'une multitude d'éléments récepteurs de lumière (28), un signal de commutation et un signal de répartition de lumière, à résolution spatiale par l'intermédiaire des éléments récepteurs de lumière (28), sont générés à partir des signaux de réception des éléments récepteurs de lumière (28),
le signal de répartition de lumière à résolution spatiale est fonction de l'intensité ou du niveau de réception en dépendance de l'emplacement sur le récepteur de lumière (26),
**caractérisé en ce que**
le signal de répartition de lumière à résolution spatiale est généré en parallèle avec la génération du signal de commutation, et **en ce que** il est prévu une deuxième multitude de canaux de traitement (50₁ ... 50ₙ, 50ₘ) pour des signaux de réception des éléments récepteurs de lumière (28), les éléments récepteurs de lumière (28) étant connectés à un canal de traitement respectif (50₁ ... 50ₙ, 50ₘ) au moyen d'une unité de multiplexage.
